# EUROPÄISCHE PATENTSCHRIFT

(11) **EP 2 261 979 B1**
(45) Veröffentlichungstag und Bekanntmachung des Hinweises auf die Patenterteilung: **11.09.2013**
(21) Anmeldenummer: 10010395.1
(22) Anmeldetag: 30.09.2003
(51) Int. Cl.: H01L 27/28, H01L 27/30, G06K 19/16

(54) **Folie mit organischen Halbleitern**
Polymer sheet with organic semiconductors
Feuille avec des semiconducteurs organiques

(30) Priorität: 02.10.2002 DE 10246241
(43) Veröffentlichungstag der Anmeldung: 15.12.2010
(62) Teilanmeldung aus: 03773464.7
(73) Patentinhaber: Leonhard Kurz Stiftung & Co. KG, 90763 Fürth (DE)
(72) Erfinder: Lutz, Norbert, 90607 Rückersdorf (DE); Brehm, Ludwig, 91325 Adelsdorf (DE); Wild, Heinrich, 91074 Herzogenaurach (DE)
(74) Vertreter: Zinsinger, Norbert

(56) Entgegenhaltungen:
- EP-A- 0 442 123
- WO-A1-01/73845
- JOHN A ROGERS ET AL: "Organic Smart Pixels and Complementary Inverter Circuits Formed on Plastic Substrates by Casting and Rubber Stamping", IEEE ELECTRON DEVICE LETTERS, IEEE SERVICE CENTER, NEW YORK, NY, US, Bd. 21, Nr. 3, 1. März 2000 (2000-03-01), Seiten 100-103, XP011018737, ISSN: 0741-3106
- TZUNG-FANG GUO ET AL: "High performance polymer light-emitting diodes fabricated by a low temperature lamination process", ADV. FUNCT. MATER. (GERMANY), ADVANCED FUNCTIONAL MATERIALS, OCT. 2001, WILEY-VCH, GERMANY, Bd. 11, Nr. 5, Oktober 2001 (2001-10), Seiten 339-343, XP001083338, ISSN: 1616-301X

## Beschreibung

Organische Feldeffekttransistoren (OFETs) bestehen aus einer organischen Halbleiterschicht zwischen und über einer Source- und zumindest einer Drain-Elektrode, einer organischen Isolationsschicht über der halbleitenden Schicht und einer Gate-Elektrode. Source-, Drain- und Gate-Elektrode können aus Metallen oder aus organischen, leitfähigen Polymeren bestehen. Organische Elektrodenmaterialien sind beispielsweise Polyanilin und Polypyrrol. Als Halbleiter werden zum Beispiel Polythiophen, als Isolator Polyvinylphenol eingesetzt.

Zur Herstellung von OFETs oder anderen Bauelementen aus organischen Polymeren ist eine Strukturierung der leitfähigen Elektrodenschichten erforderlich. Die Strukturierung der anderen Schichten ist nicht unbedingt erforderlich, kann aber die Leistungsfähigkeit der Bauelemente aus organischen Polymeren verbessern.

WO 02/25750 beschreibt die Herstellung von Elektroden oder Leiterbahnen mit einem Lithographie-Verfahren. Hierbei wird die leitfähige organische Schicht aus dotiertem Polyanylin (PANI) oder Polyethylendioxythiophen (PEDOT) durch Rakeln, Aufsprühen, Spin-Coating oder Siebdruck flächig auf das Substrat, beispielsweise eine Folie, aufgebracht. Hierauf wird eine dünne Schicht aus Photoresist aufgebracht und strukturiert belichtet. Bei der Entwicklung wird die freigelegte Polyanilinschicht durch Einwirkung des Entwicklers deprotoniert und damit nichtleitend. Mit einem Lösungsmittel wird der verbliebene Photoresist gelöst. Vor oder nach diesem Schritt wird die nichtleitfähige Matrix der organischen Schicht mit einem nichtbasischen Lösungsmittel herausgelöst.

Alternativ ist es auch möglich, die freigelegten Bereiche vor dem Lösen des Photoresists durch reaktives Ätzen oxidativ zu entfernen.

WO 02/25750 beschreibt ferner, daß auf die flächige Funktionspolymerschicht eine chemische Verbindung, die deprotonierend wirkt, zur Strukturierung aufgedruckt wird. Die Verbindung ist bevorzugt eine Base. Durch eine anschließende Spülung werden nichtleitende Bereiche selektiv entfernt.

Es ist von Nachteil, daß das lithographische Verfahren nur für das Material Polyanilin funktioniert. Im Stand der Technik ist ferner nicht bekannt, Rollenware mit lithographischen Verfahren zu strukturieren. Mit anderen Strukturierungsverfahren, zum Beispiel Drucken, beträgt der minimal mögliche Abstand zwischen Source- und Drain-Elektrode zumindest 30 µm bis 50 µm. Angestrebt werden aber Längen von ungefähr 10 µm, um die Leistungsfähigkeit des OFET zu erhöhen.

WO 02/47183 schlägt für die Strukturierung der leitfähigen, organischen Schicht sowie der anderen Schichten in einem OFET vor, den Funktionspolymer in Vertiefungen einer Formschicht einzubringen. Die Formschicht besteht aus einem anderen organischen Material mit isolierenden Eigenschaften, in das ein Stempel eingedrückt wird. Dieses Material ist beispielsweise ein UV- oder ein thermisch härtbarer Lack, der vollflächig auf ein Substrat aufgebracht ist. Durch Bestrahlung, beispielsweise mittels UV-Licht, wird der Lack ausgehärtet und es werden in der Formschicht Vertiefungen erzeugt. In diese Vertiefungen wird dann das Funktionspolymer hineingerakelt. Mit diesem Verfahren können somit extrem feine Strukturen mit lateralen Abmessungen im Bereich von 2 - 5 µm erzeugt werden. Die Rakelmethode ist zudem nicht materialspezifisch, das heißt zur Strukturierung aller Schichten eines OFET geeignet. Neben Polyanylin können andere leitfähige oder halbleitende organische Materialien, wie beispielsweise Polypyrrol, Polythiophen oder auch Polyvinylphenol eingerakelt und somit strukturiert werden. Außerdem ist die Viskositätsspanne für das Rakeln ungleich größer als für das Drucken, so daß die Funktionspolymere weitgehend in ihrer Konsistenz belassen werden können. Zudem können relativ dicke Schichten im Bereich bis zu 1 µm erzeugt werden. Es wird ferner vorgeschlagen, das Verfahren im kontinuierlichen Rollendruck einzusetzen. Das Band besteht dabei aus einem Substratmaterial mit dem aufgebrachten Formpolymer, das ein UV-härtbarer, aber auch ein thermisch härtbarer Lack sein kann. Die Vertiefungen werden zunächst mit einer Stempelrolle eingeprägt und das Formpolymer durch UV-Bestrahlung angehärtet.

Mit einer danach angeordneten UV-Lampe wird der Lack nachgehärtet. In den strukturierten Lack wird dann das Funktionspolymer mit einem Rakel eingerakelt.

DE 10033112 beschreibt ein Verfahren, das das in die Form gefüllte Funktionspolymer mit Hilfe eines Tampons abnimmt und dann auf das Subtrat oder bereits vorhandene Schichten aufbringt.

Der Artikel "Organic Smart Pixels and Complementary Inverter Circuits Formed on Plastic Substrates by Casting and Rubber Stamping" IEEE Electron Device Letters 21 (2000), 100 - 103 (XP011018737) offenbart die Herstellung eines Displays auf einem flexiblen Kunststoffsubstrat, welches neben einem organischen Feldeffekttransistor auch noch eine LED umfasst.

Die WO 01/73845 A1 beschreibt, einen integrierten Schaltkreis mit einem speziellen Speicherelement auszustatten, bei dem eine elektrisch leitfähige Brücke zwischen zwei Elektroden ein organisches Material umfasst. Ein mittels eines derartigen integrierten Schaltkreises hergestellter Transponder kann hierbei in ein Sicherheitspapier integriert werden.

Die EP 0 442 123 A1 beschreibt ein Verfahren zur Herstellung einer elektronischen Komponente, bei der eine Grenzfläche zwischen einem halbleitenden Polymer und einer anderen Materialschicht durch Schmelzen des leitfähigen Polymers hergestellt wird.

Der Erfindung liegt nun die Aufgabe zugrunde, die Herstellung leistungsfähiger Bauelemente in organischer Halbleitertechnologie zu verbessern und/oder den Aufbau verbesserter Bauelemente in organischer Halbleitertechnologie anzugeben.

Diese Aufgabe wird durch eine Folie nach Anspruch 1 gelöst. solchen Folie nach Anspruch 11 gelöst.

Durch die Herstellung von elektronischen Schaltungen in organischer Halbleitertechnologie nicht wie bisher üblich auf einem Wafer, sondern als Teil einer Folie, ergeben sich große produktionstechnische Vorteile. Bewährte und erprobte Methoden der Folientechnologie sowie bestehende Produktionsanlagen können für die Herstellung solcher elektronischen Schaltungen eingesetzt werden, wodurch sich erhebliche Kostenvorteile ergeben.

Besondere Vorteile ergeben sich bei der Implementierung solcher Bauelemente in organischer Halbleitertechnologie in Präge- oder Laminierfolien. Hierdurch wird die Möglichkeit eröffnet, derartige elektronische Schaltungen in vielfältiger Weise auf Produkten und Zwischenprodukten zu applizieren. Es wird ein kostengünstig zu produzierendes Zwischenprodukt geschaffen, das in vielfältiger Weise kundenspezifisch weiterverwendet und angepaßt werden kann. Der Fertigungsprozeß wird dadurch flexibilisiert und die Produktionskosten gesenkt. Weiter hat sich gezeigt, daß die für die Herstellung von Präge- und Laminierfolien verwendete Folientechnologie und Fertigungsverfahren besonders gut geeignet ist, derartige elektronische Schaltungen zu realisieren.

Gemäß einem bevorzugten Ausführungsbeispiel der Erfindung weist eine derartige Prägefolie, eine Laminierfolie oder ein Folienelement eine Trägerfolie, zumindest eine Schicht aus einem organischen Halbleitermaterial, insbesondere Polythiophen, zumindestens eine Schicht aus einem elektrisch isolierenden Material und zwei oder mehr bereichsweise und musterförmig ausgeformte Schichten aus einem elektrisch leitfähigen Material auf, die als Elektrodenschichten wirken. Die elektrisch leitfähigen Schichten bestehen hierbei vorzugsweise aus einem organisch leitfähigen Material, insbesondere Polyanilin oder Polypyrol. Die elektrisch isolierende Schicht besteht vorzugsweise aus einem organischen Isolationsmaterial, insbesondere Polyvinylphenol. Weiter weist die Folie bevorzugt eine Ablöseschicht und eine Klebeschicht, sowie eine oder mehrere an Funktionspolymerschichten angrenzende Lackschichten auf.

Weitere Vorteile sind dadurch erzielbar, daß die elektrisch leitfähige Schicht, die Schicht aus einem Halbleitermaterial und die Isolationsschicht in der Regel transparent sind. Hierdurch ist es möglich, das optische Erscheinungsbild der Folie durch die Gestaltung weiterer Schichten der Präge- oder Laminierfolie zu beeinflussen und eine Mehrfachnutzung der Folie z. B. als elektronische Schaltung und als dekoratives Element, zu vereinfachen.

In der Folie wird eine elektrische Funktionalität, insbesondere die mindestens eines elektronischen Bauelements in organischer Halbleitertechnologie, mit optischen Merkmalen kombiniert. Die Folie weist demnach zum einen eine elektronische Schaltung mit einem oder mehreren elektronischen Bauelementen in organischer Halbleitertechnologie auf und bietet zum anderen dem Betrachter ein oder mehrere optische (Sicherheits-)merkmale. Hierzu kann die Folie beispielsweise eine zwischen Schichten der Folie abgeformte räumliche Struktur aufweisen, die zum einen eine Schicht eines elektronischen Bauelements in organischer Halbleitertechnologie musterförmig strukturiert und zum anderen einen beugungsoptischen Effekt generiert, der ein optisches Merkmal bildet. Die räumliche Struktur kann hierbei von der Überlagerung einer Makro- und einer Mikrostruktur gebildet werden, wobei die Makrostruktur für die musterförmige Strukturierung einer elektrischen Funktionsschicht und die Mikrostruktur für die Erzeugung eines beugungsoptischen Effekts und damit für die Generierung eines optischen (Sicherheits-)merkmals verantwortlich ist. Damit werden von einer räumlichen Struktur zwei Funktionen erbracht, zum einen die Implementierung eines elektronischen Bauelements in organischer Halbleitertechnologie und zum anderen die Generierung eines optischen Merkmals für den Betrachter der Folie.

Weiter kann die Folie eine oder mehrere holographisch-optische oder diffraktive Schichten zur Erzeugung eines beugungsoptischen Sicherheitsmerkmals, eine oder mehrere Dünnfilmschichtfolgen zur Erzeugung eines optischen Sicherheitsmerkmals mittels Interferenz sowie eine oder mehrere Dekorschichten aufweisen, mittels denen zusätzlich zu der elektrischen Funktionalität eine optische Funktionalität, beispielsweise die Generierung ein oder mehrerer optischer (Sicherheits-)merkmale oder dekorativer Effekte, verwirklicht wird.

Eine derart ausgestaltete Folie kann so als optisches Sicherungselement, beispielsweise zur Sicherung von Ausweisen, Banknoten, Kreditkarten oder Geldkarten, sowie Waren dienen. Hierbei kann eine derartige Folie neben optischen Sicherheitsmerkmalen auch elektrische Sicherheitsmerkmale bieten. Durch die Kombination solcher optischen und elektrischen Sicherheitsmerkmale wird die Fälschungssicherheit erheblich erhöht. Weiter ist es auch möglich, daß die Folie zwei oder mehr übereinander angeordnete, ein optisches Sicherheitsmerkmal erzeugende Schichten aufweist, wobei eine oder mehrere Funktionsschichten eines elektronischen Bauelementes in organischer Halbleitertechnologie zwischen derartigen optisch aktiven Schichten angeordnet sind. Hierdurch wird die Fälschungssicherheit erheblich erhöht, da jeder Manipulationsversuch des optischen oder des elektrischen Sicherheitsmerkmals sofort erkennbar wird und sich diese Sicherheitsmerkmale so gegenseitig schützen.

Eine besonders effektive und kostengünstige Art und Weise der Herstellung einer erfindungsgemäßen Folie besteht darin, die Strukturierung von einer oder mehreren Schichten des mindestens einen Bauelements in organischer Halbleitertechnologie durch thermisches Replizieren oder UV-Replizieren durchzuführen.

Gemäß eines bevorzugten Ausführungsbeispiels der Erfindung wird in die zu replizierende Schicht eine räumliche Struktur repliziert, deren Strukturtiefe größer oder gleich der Schichtdicke der zu replizierenden Schicht ist, so daß die zu replizierende Schicht partiell durch die Replikation vollständig durchtrennt ist. Durch die Replikation wird so eine gemäß der räumlichen Struktur musterförmig strukturierte elektrische Funktionsschicht geschaffen. Durch dieses Verfahren lassen sich sehr hohe Auflösungen, beispielsweise im Bereich von 10 µm bis 100 nm erzielen. Aufgrund der Möglichkeit derart kleine Strukturen realisieren zu können, läßt sich die Packungsdichte als auch die Leistungsfähigkeit der implementieren elektrischen Schaltungen verbessern. Weitere Vorteile dieses Verfahrens bestehen darin, daß in einem einzigen Schritt eine hochauflösende Strukturierung einer elektrischen Funktionsschicht möglich ist. Die Strukturierung der elektrischen Funktionsschicht kann mit hoher Geschwindigkeit, insbesondere als Rolle-zu-Rolle-Prozeß, und mit vergleichsweise geringen Produktionskosten erfolgen.

Gemäß eines weiteren bevorzugten Ausführungsbeispiels der Erfindung wird in die zu replizierende Schicht eine räumliche Struktur repliziert, deren Strukturtiefe kleiner als die Schichtdicke der zu replizierenden Schicht ist. Auf die replizierte Schicht wird eine elektrische Funktionsschicht aus einem Material aufgebracht, das bei Aushärtung eine vordefinierte Volumenreduktion erfährt. Dieses Material wird auf die replizierte Schicht in einer Auftragsmenge aufgebracht, die so gewählt ist, daß aufgrund des Volumenschrumpfes bei Aushärtung eine gemäß der replizierten Struktur musterförmig strukturierte Funktionsschicht verbleibt. Weiter ist es hier auch möglich, daß auf die replizierte Schicht eine elektrische Funktionsschicht aufgebracht wird und daß die elektrische Funktionsschicht anschließend in einer Tiefe abgetragen wird, die so gewählt ist, daß nach Abtragung eine der gemäß der replizierten Struktur musterförmig strukturierte Funktionsschicht verbleibt. Auch mit einem derartigen Verfahren lassen sich hohe Auflösungen von elektrischen Funktionsschichten erreichen, so daß sich die hierzu oben beschriebenen Vorteile auch bei dieser Vorgehensweise ergeben.

Alternativ oder zusätzlich ist es auch noch möglich, ein oder mehrere der für die Funktion der Bauelemente erforderlichen Elektroden-, Isolations- und halbleitenden Schichten durch Druckverfahren, insbesondere durch Tampondruck, teilflächig oder vollflächig in den Folienaufbau einzubringen.

Die Erfindung wird im Folgenden anhand von mehreren Ausführungsbeispielen unter Zurhilfenahme der beiliegenden Zeichnungen beispielhaft beschrieben.
- Fig. 1: zeigt eine Schnittdarstellung einer.
- Fig. 2: zeigt eine Schnittdarstellung einer.
- Fig. 3: zeigt eine Darstellung einer Vorrichtung zur Replikation von Strukturen elektrischer Bauelemente in organischer Halbleitertechnologie, insbesondere organischer Feldeffekttransistoren.
- Fig. 4a: zeigt eine funktionale Darstellung der Strukturierung einer Schicht eines Bauelements in organischer Halbleitertechnologie gemäß eines ersten Ausführungsbeispiels.
- Fig. 4b und 4c: zeigen funktionale Detaildarstellungen der Strukturierung einer Schicht.
- Fig. 5: zeigt eine Schnittdarstellung einer Folie, bei der ein oder mehrere Schichten eines Bauelements organischer Halbleitertechnologie gemäß des Verfahrens nach Fig. 4 repliziert sind.
- Fig. 6a bis Fig. 6e: zeigen Funktionsdarstellungen der Strukturierung von einer Schicht eines Bauelements in organischer Halbleitertechnologie durch Replikation.
- Fig. 7: zeigt eine Schnittdarstellung einer Folie, bei der eine oder mehrere Schichten eines Bauelements in organischer Halbleitertechnologie gemäß den Verfahren nach Fig. 6a bis Fig. 6e strukturiert sind.
- Fig. 8a: zeigt eine funktionelle Darstellung der Replikation einer Schicht eines Bauelements in organischer Halbleitertechnologie.
- Fig. 8b: zeigt eine funktionelle Darstellung der Replikation einer Schicht eines Bauelements in organischer Halbleitertechnologie.
- Fig. 9a und Fig. 9b: zeigen Schnittdarstellungen von Folien.

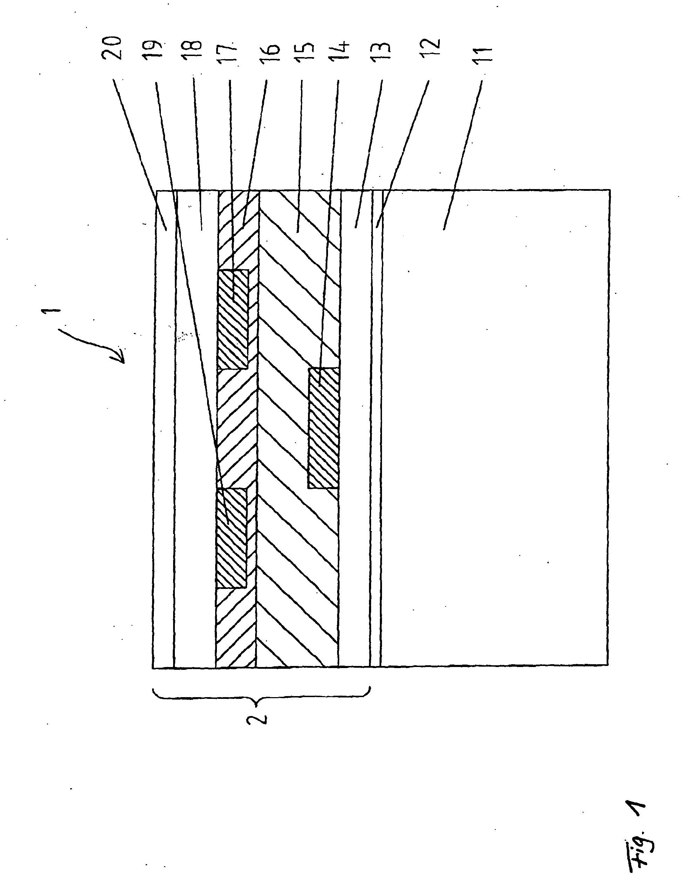

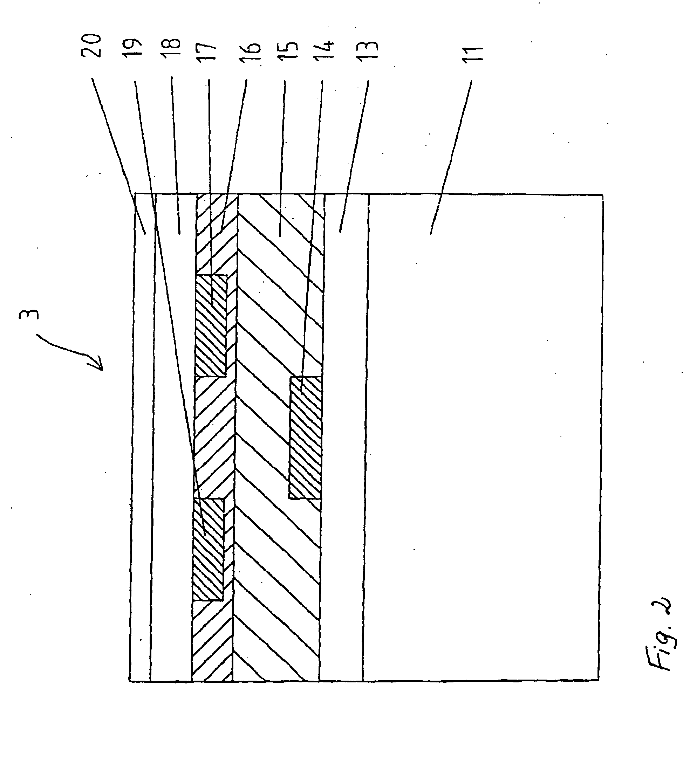

Fig. 1 zeigt eine Prägefolie, die zumindest ein Bauelement in organischer Halbleitertechnologie, insbesondere organische Feldeffekttransistoren (OFETs), beinhaltet. Bei einer solchen Prägefolie handelt es sich insbesondere um eine Heißprägefolie. Fig. 2 zeigt den Aufbau einer Laminierfolie, die mindestens ein Bauelement in organischer Halbleitertechnologie, insbesondere organische Feldeffekttransistoren (OFETs), beinhaltet. Die Erfindung ist jedoch nicht auf derartige Folientypen beschränkt.

Fig. 1 zeigt eine Prägefolie 1 mit einer Trägerfolie 11 und einer auf diese aufgebrachten Übertragungslage 2. Zwischen Trägerfolie 11 und Übertragungslage 2 ist eine Ablöseschicht 12 vorgesehen, die dazu dient, das Ablösen der Übertragungslage 2 von der Trägerfolie 11 zu erleichtern. Auf die Ablöseschicht 12 könnte hierbei auch verzichtet werden.

Die Übertragungslage 2 weist eine erste Lackschicht 13 und eine zweite Lackschicht 18, eine Isolationsschicht 15 aus einem elektrisch isolierenden Material und eine Schicht 16 aus einem organischen Halbleitermaterial auf. Weiter weist die Übertragungslage 2 zwei musterförmig ausgeformte Elektrodenschichten aus einem elektrisch leitfähigen Material auf, von denen in Fig. 1 ein Teilbereich 14, der eine Gate-Elektrode bildet, und zwei Teilbereiche 17 und 19, die eine Source-Elektrode bzw. eine Drain-Elektrode bilden, gezeigt sind.

Alternativ ist es auch möglich, die Anordnung der Gate- bzw. der Source- und Drain-Elektroden in der Übertragungslage 2 zu vertauschen, d.h. die Source- und Drain-Elektrode in der Zeichnung unten über der Lackschicht 13 und die Gate-Elektrode in der Zeichnung oben, neben und über der halbleitenden Schicht 16, vorzusehen.

Fig. 2 zeigt eine Laminierfolie 3 mit einem analogen Schichtaufbau. Der genaue Aufbau der Schichten wird so im folgenden lediglich anhand der Prägefolie 1 erläutert.

Bei der Trägerfolie 11 handelt es sich um eine Kunststofffolie mit einer Stärke von 6 µm bis 200 µm, vorzugsweise mit einer Stärke von 19 µm bis 38 µm. Bei der Trägerfolie 11 handelt es sich vorzugsweise um eine Polyesterfolie.

Auf die Trägerfolie 11 wird sodann vollflächig die Ablöseschicht 12 in einer Dicke von 0,01 bis 0,2 µm aufgebracht. Sie ist vorzugsweise als eine bei Wärmeentwicklung weich werdende Schicht ausgebildet, die beim Aufbringen der Heißprägefolie auf das Substrat die Ablösung der weiteren Schichten von der Trägerfolie 11 gestattet.

Bei der ersten Lackschicht 13 handelt es sich um eine Schutzlackschicht, die im allgemeinen vollflächig und zwar in einer Schichtdicke von 0,5 bis 5,0 µm, vorzugsweise von 1 bis 2 µm, auf die Ablöseschicht aufgebracht wird.

Auf die Lackschicht 13 wird nun die erste Elektrodenschicht mit der Gate-Elektrode 14 aufgebracht. Die erste Elektrodenschicht besteht hierbei vorzugsweise aus einem elektrisch leitfähigen Polymer, vorzugsweise Polyanilin und Polypyrrol. Weiter ist es möglich, für die erste Elektrodenschicht Metalle, beispielsweise Gold oder Silber, zu verwenden.

Die erste Elektrodenschicht kann hierbei beispielsweise durch ein Druckverfahren (Tiefdruck, Siebdruck) oder durch ein Beschichtungsverfahren bereits partiell und musterförmig auf die Lackschicht 13 aufgebracht werden. Es ist jedoch auch möglich, die erste Elektrodenschicht vollflächig oder teilflächig auf die Lackschicht 13 aufzubringen und sodann durch ein im späteren beschriebenes Replikationsverfahren, durch ein Belichtungs- und Ätzverfahren oder durch Ablation, beispielsweise mittels eines gepulsten Lasers, partiell wieder zu entfernen.

Je nach dem verwendeten Auftragsverfahren wird das elektrisch leitfähige Material hierbei in flüssiger Form, in gelöster Form oder als Suspension auf die Lackschicht 13 aufgebracht.

Die Isolationsschicht 15 besteht vorzugsweise aus einem organischen Isolationsmaterial, beispielsweise Polyvinylphenol. Es ist jedoch auch möglich, als Material für die Isolationsschicht 15 Oxidschichten, beispielsweise Metalloxide, zu verwenden. Organische Isolationsschichten werden hierbei mittels eines der oben beschriebenen Verfahren auf die musterförmig strukturierte Elektrodenschicht in flüssiger Form, gelöster Form oder als Suspension aufgebracht. Anschließend wird die Isolationsschicht 15 durch Trocknen oder in sonstiger Weise verfestigt. Oxidschichten werden durch thermisches Aufdampfen oder Sputtern im Vakuum aufgebracht.

Auf die Isolationsschicht 15 wird nun die Schicht 16 aus einem organischen Halbleitermaterial vollflächig oder teilflächig aufgebracht. Als organisches Halbleitermaterial kann hierbei Polythiophen verwendet werden. Das organische Halbleitermaterial wird hierbei mittels eines der oben beschriebenen Verfahren auf die Isolationsschicht 15 in flüssiger, gelöster Form oder als Suspension aufgebracht und sodann verfestigt. Hierbei ist es auch möglich, die Schicht 16 in gleicher Weise wie die erste Elektrodenschicht musterförmig zu strukturieren, wodurch sich die in Fig. 1 und Fig. 2 gezeigte Ausformung der Schicht 16 ergibt.

Anschließend wird die zweite Elektrodenschicht mit der Source- bzw. Drain-Elektrode 17 bzw. 19 in derselben Art und Weise wie oben beschrieben auf die Schicht 16 aufgebracht. In Bezug auf die für diese Schicht verwendeten Materialien und Strukturierungsverfahren wird auf die Ausführungen zu der ersten Elektrodenschicht verwiesen.

Anschließend werden die Lackschicht 18 und die Kleberschicht 20 vollflächig aufgebracht. Die Schichtdicke der Schicht 18 liegt vorzugsweise bei 2 -10 µm. Bei der Kleberschicht 20 handelt es sich um eine bei Transferfolien bzw. Heißprägefolien an sich übliche und bekannte Kleberschicht einer Dicke von etwa 1 bis 10 µm, wobei die Kleberschicht für eine Heißprägefolie so zusammengesetzt ist, daß sie erst bei entsprechender Wärmeeinwirkung klebrig wird.

Die Schichten 12, 13, 18 und 20 können nach folgenden Rezepturen hergestellt sein:

| Ablöseschicht 12 (Trennschicht): | |
|---|---|
| Toluol | 99,5 Teile |
| Esterwachs (Tropfpunkt 90°C) | 0,5 Teile |
| Lackschicht 13 (Schutzlackschicht): | |
| Methylethylketon | 61,0 Teile |
| Diaketonalkohol | 9,0 Teile |
| Methylmethanacrylat (Tg = 122°C) | 18,0 Teile |
| Polyethylendispersion (23% in Xylol)(Erweichungspunkt 140°C) | 7,5 Teile |
| Hochmolekulares Dispergieradditiv (40 %, Aminzahl 20) | 0,5 Teile |
| Extender (Aluminiumsilikat) | 20,0 Teile |

| Lackschicht 18 (Zwischenschicht): | |
|---|---|
| Methylethylketon | 40,0 Teile |
| Toluol | 22,0 Teile |
| Ethylen-Vinylacetat-Terpolymer (Fp. = 60°C) | 2,5 Teile |
| Polyvinylchlorid (Tg: 89°C) | 5,5 Teile |
| Polyvinylchlorid (Tg: 40°C) | 3,0 Teile |
| Dispergieradditiv (50 %, Säurezahl 51) | 1,0 Teile |
| Titandioxid (d = 3,8 - 4,2 g/cm³) | 26,0 Teile |

| Kleberschicht 20: | |
|---|---|
| Methylethylketon | 55,0 Teile |
| Toluol | 12,5 Teile |
| Ethanol | 3,5 Teile |
| Polyvinylacetat (Erweichungspunkt 80°C) | 6,0 Teile |
| Butyl-/Methylmethacrylat (Tg: 80°C) | 8,0 Teile |
| Ethylmethacrylatharz (Tg: 63°C) | 3,0 Teile |
| Methacrylatcopolymere (Tg: 800°C) | 5,0 Teile |
| Ungesättigtes Polyesterharz (Erweichungspunkt 103°C) | 3,5 Teile |
| Siliciumdioxid | 3,5 Teile |

Die Lackschichten 13 und 18 haben hier zum einen elektrisch isolierende Eigenschaften und haben im weiteren die Funktion von Schutzschichten für die von ihnen umschlossenen elektrischen Funktionspolymerschichten.

Auf die erste Lackschicht 13 und die zweite Lackschicht 18 könnte auch verzichtet werden.

Organische Halbleitermaterialien, organisch leitfähige Materialien und organische Isolationsmaterialien werden hierbei von organischen, metallorganischen und/oder anorganischen Kunststoffen gebildet, die die jeweiligen elektrischen Eigenschaften besitzen. Als Funktionspolymer werden hierbei solche organische, metallorganische und/oder anorganische Materialien bezeichnet, die bei dem Aufbau von Bauelementen in organischer Halbleitertechnologie Verwendung finden können. Der Begriff Funktionspolymer umfaßt demnach auch nichtpolymere Komponenten.

Der in Fig. 1 gezeigte Ausschnitt der Folie 1 weist die Gate-Elektrode 14, die Source-Elektrode 17 und die Drain-Elektrode 19 auf, so daß von dem in Fig. 1 gezeigten Bereich der Folie 1 durch das Zusammenwirken dieser Elektroden mit der Isolationsschicht 15 und der Schicht 16 aus einem organischen Halbleitermaterial ein organischer Feldeffekttransistor implementiert wird. Je nach Strukturierung der ersten und zweiten Elektrodenschicht sowie u. U. der Strukturierung der Isolationsschicht 15 und der Schicht 16 aus einem Halbleitermaterial kann in der Folie 1 eine komplexe elektronische Schaltung implementiert werden, die aus einer Vielzahl von Bauelementen in organischer Halbleitertechnologie besteht.

Unter Bauelement in organischer Halbleitertechnologie ist hierbei ein elektronisches Bauelement zu verstehen, das eine organische Halbleiterschicht oder Halbleiter-Schichtbereich als funktionelle Komponente umfaßt, beispielsweise Transistoren, FET's (Feldeffekttransistoren), Triacs, Dioden usw..

Hierbei ist es auch möglich, daß mehrere der in Fig. 1 dargestellten Schichten 13 bis 16 übereinander angeordnet sind, um so zwei oder mehr übereinander angeordnete Bauelemente in organischer Halbleitertechnologie in der Folie 1 zu verwirklichen.

Zur Verwirklichung der Bauelemente in organischer Halbleitertechnologie kann hierbei sowohl die erste Elektrodenschicht als auch die zweite Elektrodenschicht, wie bereits oben geschildert, in musterförmig strukturierter Form ausgebildet sein. Es ist jedoch auch weiter möglich, daß auch die Isolationsschicht 15 und die Schicht 16 aus einem halbleitenden Material in musterförmig strukturierter Form ausgeführt ist, um die entsprechende elektrische Funktionalität zu erzielen. Für derartige musterförmige Strukturierungen werden hierbei folgende Verfahren oder eine Kombination folgender Verfahren vorgeschlagen:
Es wird vorgeschlagen, die für die Funktion der Bauelemente erforderlichen Elektroden-, Isolations- und halbleitenden Schichten durch Druckverfahren teilflächig oder vollflächig in einen Folienaufbau einzubringen.

Die für die teilflächige Bedruckung bekannten, hochauflösenden Druckverfahren weisen derzeit jedoch eine laterale Auflösung von 50 µm auf und sind daher für die Herstellung insbesondere der Source- und Drain-Elektroden nur bedingt geeignet.

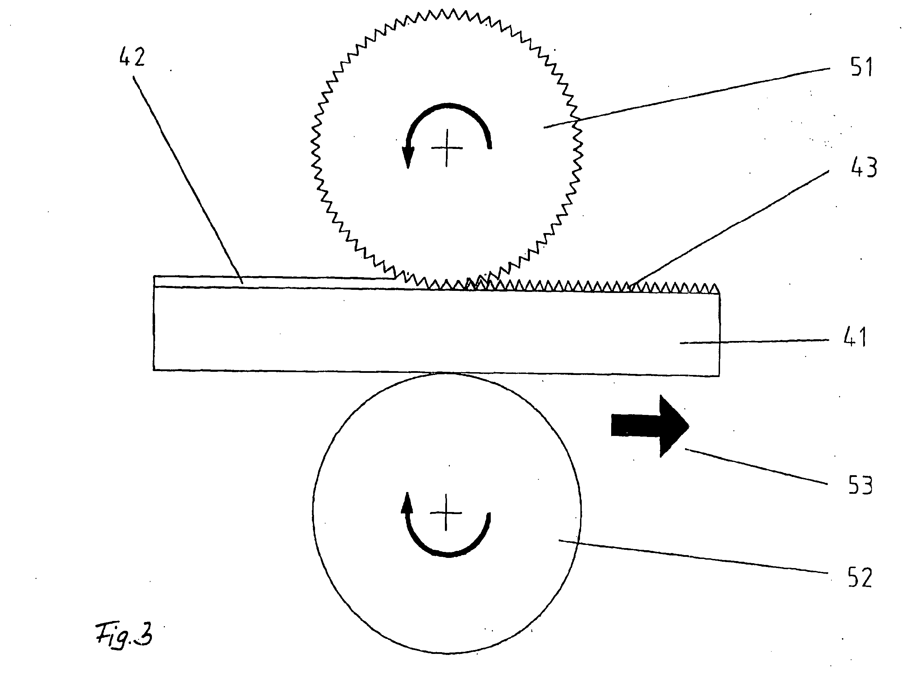

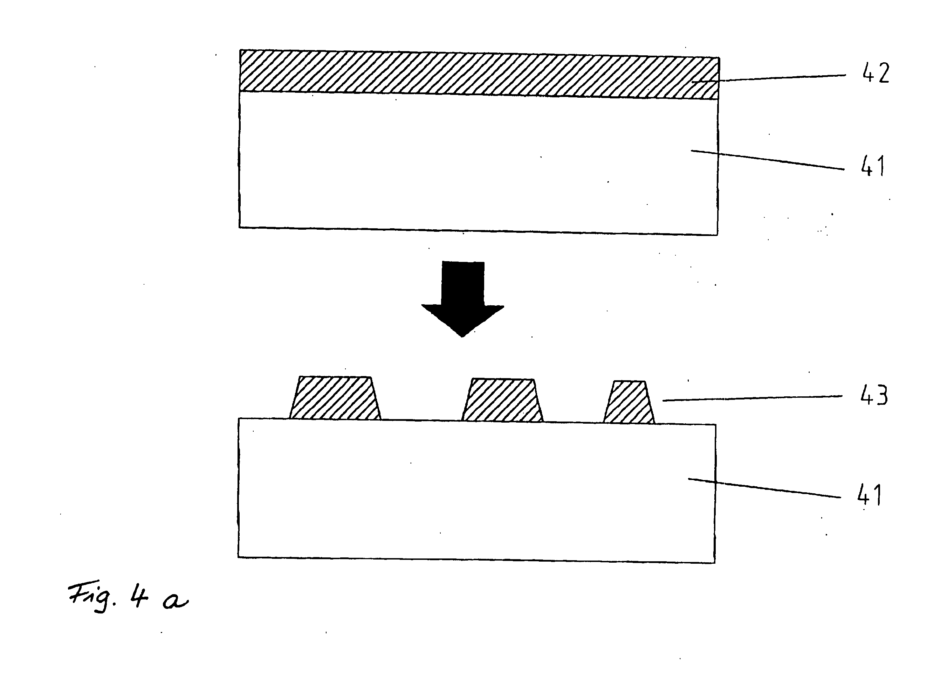

Bei dem hier bevorzugten Verfahren wird dagegen vorgesehen, zunächst eine vollflächige Bedruckung durchzuführen, und anschließend durch thermisches oder UV-Replizieren eine entsprechende Strukturierung der Schicht vorzunehmen. Eine entsprechende Vorrichtung hierfür ist in Fig. 3 gezeigt und das Resultat ist in Fig. 4a bis Fig. 4c dargestellt. Für die UV-Replikation ist zusätzlich eine nicht dargestellte UV-Lampe sowie eine ebenfalls nicht dargestellte Maske vorzusehen. Durch derartige Replizierverfahren werden sehr hohe laterale Auflösungen im Bereich von 0,5 µm bis 5 µm erreicht.

Fig. 3 zeigt eine Replizierwalze 51, eine Gegendruckwalze 52, eine Trägerfolie 41, eine Schicht 42 und eine strukturierte Schicht 43. Der Folienkörper, bestehend aus der Schicht 42 und der Trägerfolie 41, wird bei Drehung der Replizierwalze 51 und der Gegendruckwalze 52 in der in Fig. 3 angedeuteten Richtung in die Vorschubrichtung 53 befördert. Hierbei wird, wie in Fig. 3 gezeigt, eine Struktur in die Schicht 42 repliziert, so daß die Schicht 42 die in Fig. 3 gezeigte Struktur erhält und nun die strukturierte Schicht 43 bildet.

Bei der Schicht 42 handelt es sich um eine Funktionsschicht eines Bauelements in organischer Halbleitertechnologie, beispielsweise um eine Schicht des in Fig. 1 und Fig. 2 gezeigten organischen Feldeffekttransistors, beispielsweise um die erste Elektrodenschicht, die Schicht aus einem lsolationsmaterial, die zweite Elektrodenschicht oder die Schicht aus einem organischen Halbleitermaterial. Bei der Trägerfolie 41 kann es sich um die Trägerfolie 11 oder um einen mehrschichtigen Folienkörper mit der Trägerfolie 11 und einer oder mehreren darüberliegenden Schichten, beispielsweise um einen mehrschichtigen Folienkörper mit der Trägerfolie 11, der Ablöseschicht 12 und der Lackschicht 13 handeln.

Als Replikationsverfahren finden vorzugsweise thermische Replikation und UV-Replikation Anwendung.

Bei der thermischen Replikation erfolgt die Replikation durch thermische Verformung der Schicht 42. Für die Schicht 42 wird ein Material mit thermoplastischen Eigenschaften verwendet. Mittels der geheizten Replizierwalze 41 wird sodann eine Struktur in die Schicht 42 geprägt, die der Oberflächenform der Replizierwalze 51 entspricht.

Beispielsweise wird eine Polyanilin- oder Polypyrrol-Lösung mit einem Auftragsgewicht von 2,2 g/m² nach Trocknung auf den Folienkörper der Trägerfolie 41 mittels einer Tiefdruckrasterwalze aufgebracht. Die Trocknung erfolgt hierbei im Trockenkanal bei einer Temperatur von 100 bis 120 °C. In die Schicht 42 wird sodann bei etwa 130 °C mittels der beispielsweise aus Nickel bestehenden Replizierwalze die Struktur eingeprägt. Zum Prägen der Struktur wird die Replizierwalze hierbei vorzugsweise elektrisch aufgeheizt. Anstelle einer Replizierwalze ist es hier auch möglich, eine Replizier-Matrize zu verwenden. Eine derartige Matrize kann vor dem Abheben von der Schicht 42 wieder abgekühlt werden. Nach Einprägung der Struktur erhärtet die Schicht 43 sodann durch Vernetzung oder in sonstiger Weise.

Bei der UV-Replikation wird für die Schicht 42 ein UV-härtbares Material verwendet. Innerhalb der Replizierwalze 51 oder nach der Replizierwalze 51 wird eine UV-Lampe vorgesehen, die eine Aushärtung der gemäß der Oberflächenstruktur der Replizierwalze 51 geformten Schicht 43 bewirkt. Weiter ist es auch möglich, daß die Replizierwalze 51 über eine glatte Oberfläche verfügt, die in Form einer Maske die Schicht 42 partiell belichtet. In den belichteten Bereichen härtet die Schicht 42 aus. In den nicht belichteten Bereichen härtet die Schicht 42 nicht aus und wird in einem Waschprozeß entfernt, so daß sich die in Fig. 3 gezeigte Strukturierung der Schicht 43 ergibt.

Wie in Fig. 4a gezeigt, wird in die Schicht 42 hierbei eine räumliche Struktur repliziert, deren Strukturtiefe größer oder gleich der Schichtdicke der zu replizierenden Schicht ist. Die zu replizierende Schicht 42 wird so durch die Replikation partiell vollständig durchtrennt, wodurch sich eine gemäß der räumlichen Struktur musterförmig strukturierte elektrische Funktionsschicht 43 ergibt.

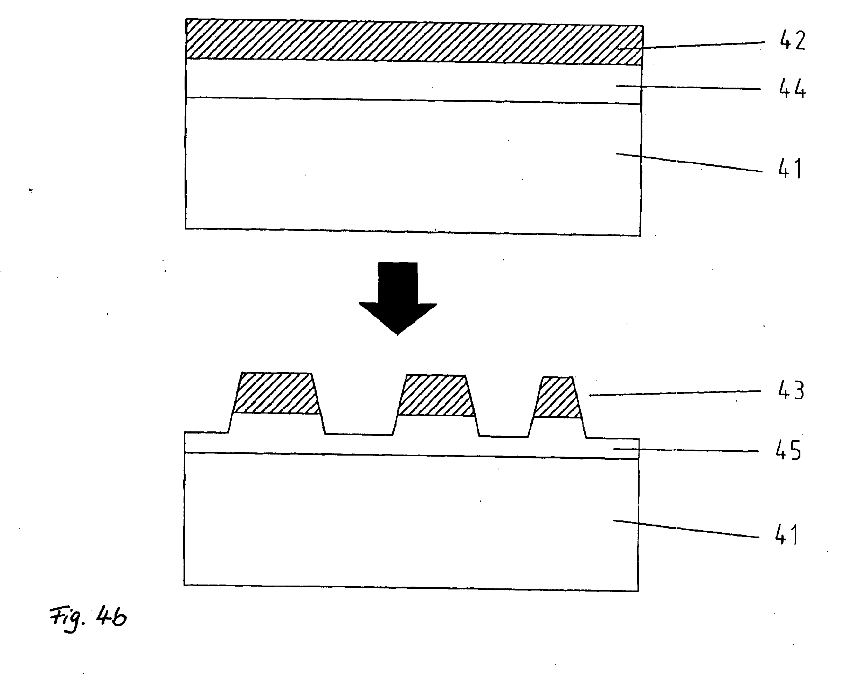

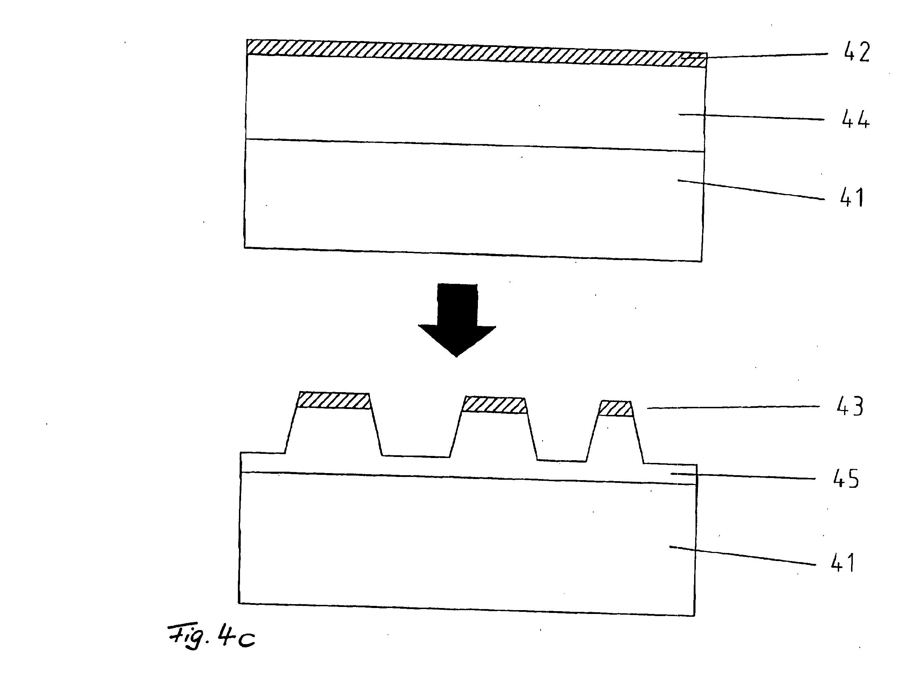

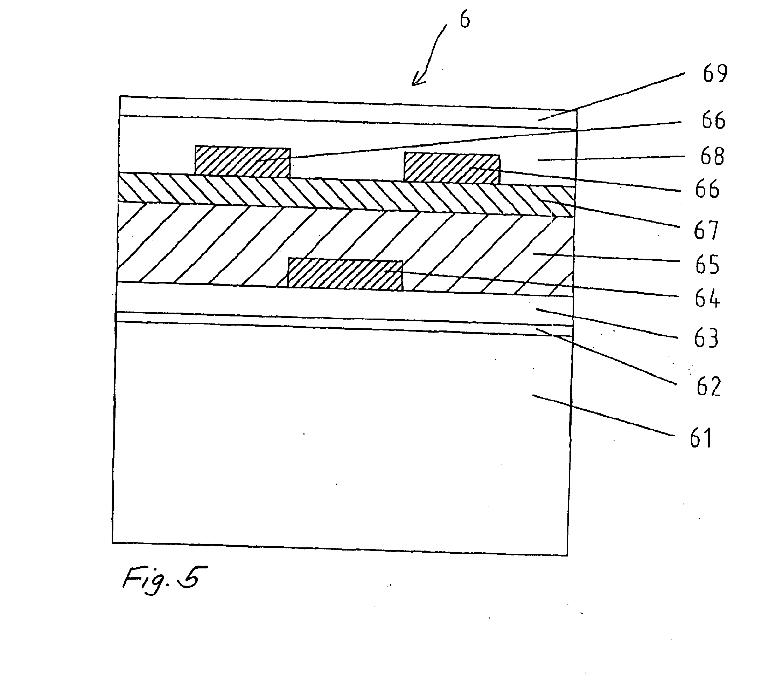

Hierbei ist es besonders bevorzugt, daß bei thermischer Replikation die Strukturtiefe größer als die Schichtdicke der Schicht 42 gewählt wird. Hierbei ist es vorteilhaft, wie in Fig. 4b gezeigt, unterhalb der Schicht 42 eine weitere Lackschicht 44, vorzugsweise aus einem Replizierlack aufzubringen. Die PrägeMatrize der Replizierwalze kann so die Schicht 42 durchprägen, ohne daß eine Schädigung der unterhalb der Lackschicht 44 liegenden Trägerfolie bzw. weiterer Schichten zu beobachten ist. In Fig. 4c ist eine Ausführungsform gezeigt, bei der die Dicke der Schicht 42 sehr viel kleiner als die Replikationstiefe gewählt ist. Hierdurch wird sichergestellt, daß eine zuverlässige Separierung der Bereiche der elektrischen Funktionsschicht 43 erreicht wird.In Fig. 5 ist nun eine Prägefolie 6 dargestellt, bei der die erste und zweite Elektrodenschicht mittels des Verfahrens nach Fig. 3 bis Fig. 4c musterförmig strukturiert worden ist.

Fig. 5 zeigt die Prägefolie 6 mit einer Trägerfolie 61, einer Ablöseschicht 62, einer Lackschicht 63, einer ersten Elektrodenschicht 64, einer Isolationsschicht 65 einer Schicht 67 aus einem organischen Halbleitermaterial, einer zweiten Elektrodenschicht 66, einer Lackschicht 68 und einer Kleberschicht 69.

Die Lackschicht 63 besteht aus einem Replizierlack. Auf die Lackschicht 63 wird die erste Elektrodenschicht 64 vollflächig aufgebracht und sodann mittels des anhand von Fig. 3 und Fig. 4a, Fig. 4b oder Fig. 4c erläuterten Replikationsverfahren musterförmig strukturiert. Sodann wird die Isolationsschicht 65 vollflächig aufgebracht Anschließend erfolgt der vollflächige Auftrag der Schicht 67 aus einem organischen Halbleitermaterial. Hierauf wird eine zweite Elektrodenschicht 66 aufgebracht und wiederum mittels des Replizierverfahrens nach Fig. 3 bis Fig. 4c musterförmig strukturiert. Es ist auch möglich, die zweite Elektrodenschicht 66 partiell durch Druck- und Beschichtungsverfahren aufzubringen, insbesondere wenn Source- und Gate-Elektroden im Schichtaufbau unten und die Gate-Elektrode im Schichtaufbau oben angeordnet sind.

Anschließend erfolgt der vollflächige Auftrag der Schichten 68 und 69.

Wie bereits oben erläutert, ist es jedoch weiter möglich, sowohl die Isolationsschicht 65 als auch die Schicht 67 aus einem organischen Halbleitermaterial mittels der Verfahren nach Fig. 3 bis Fig. 4c musterförmig zu strukturieren und damit komplexere elektronische Schaltungen in der Prägefolie 6 zu implementieren.

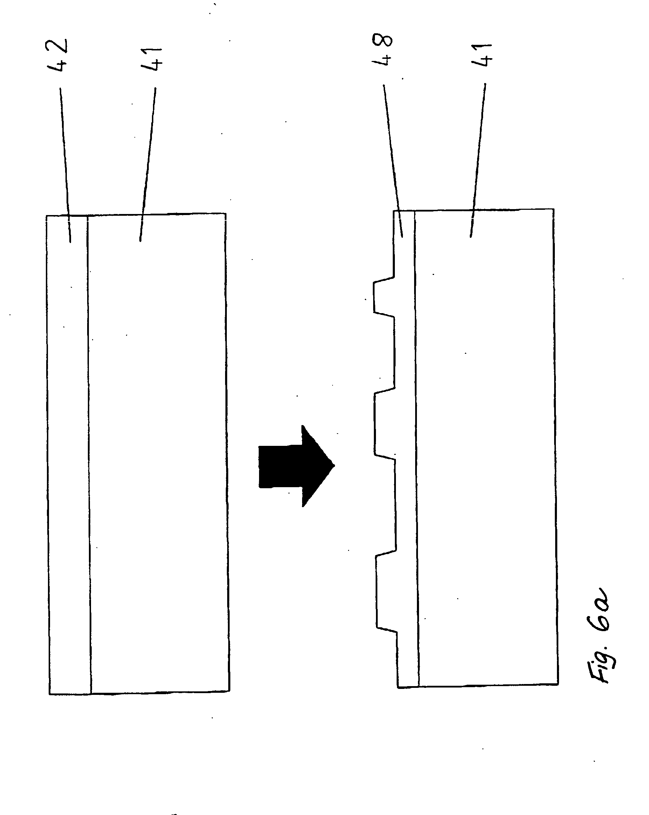

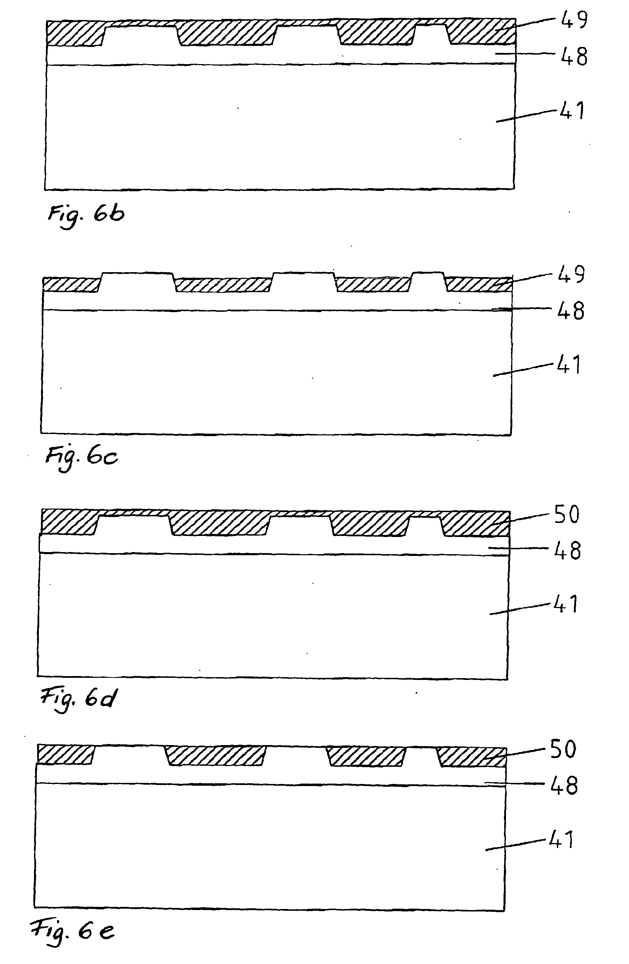

Weiter ist es auch möglich, daß in die zu replizierende Schicht eine räumliche Struktur repliziert wird, deren Strukturtiefe kleiner als die Schichtdicke der zu replizierenden Schicht ist. Dies ist beispielsweise in Fig. 6a dargestellt. In die Schicht 42 wird so mittels der anhand von Fig. 3 geschilderten Replizierverfahren eine Struktur repliziert, die die Schicht 42 nicht durchdringt und so die in Fig. 6a gezeigte Schicht 48 als Replikationsergebnis ergibt. In einem nächsten Schritt wird nun, wie in Fig. 6b gezeigt, eine elektrische Funktionsschicht 49 durch Aufdrucken, Beschichten oder Aufsprühen auf die strukturierte Schicht 48 aufgebracht. Für die elektrische Funktionsschicht 49 wird hierbei ein Material hoher Viskosität verwendet, so daß die Vertiefungen der Schicht 48 vollständig von der Schicht 49 ausgefüllt sind. Weiter wird ein Material für die elektrische Funktionsschicht 49 verwendet, das eine vordefinierte Volumenreduktion bei Aushärtung erfährt. So kann beispielsweise ein UV-aushärtbares Material verwendet werden, bevorzugt ein Acrylatsystem das bei UV-Aushärtung einen vorher klar definierten Volumenschrumpf erfährt. Weiter kann der Volumenschrumpf auch durch die Verdampfung des Lösungsmittels erzielt werden, in der das verwendete Funktionspolymer gelöst ist.

Das Material der Schicht 49 wird hierbei in einer Auftragsmenge pro Flächeneinheit aufgebracht, bei der zum einem die Vertiefungen der Schicht 48 vollständig von dem Material der Schicht 49 ausgefüllt sind, andererseits jedoch bei Aushärtung der Schicht 49 ein Volumenschrumpf erfolgt, der dazu führt, daß die Schicht 49 nunmehr die Vertiefungen der Schicht 48 ganz oder teilweise ausfüllt, nicht mehr jedoch die Plateaus der Schicht 48 bedeckt. Dies ist beispielsweise in Fig. 6c gezeigt, wo erkennbar ist, daß die Schicht 49 nach Aushärtung lediglich die Vertiefungen der Schicht 48 zu 95 % ausfüllt. Hierdurch wird erreicht, daß nach Aushärtung der Schicht 49 eine gemäß der replizierten Struktur musterförmig strukturierte elektrische Funktionsschicht 49 verbleibt.

Alternativ oder zusätzlich ist es auch möglich, wie in Fig. 6d gezeigt, eine elektrische Funktionsschicht 50 auf die Schicht 48 aufzubringen, die nach Aushärtung die Schicht 48 vollständig bedeckt und anschließend die Schicht 50, wie in Fig. 6e gezeigt, in einer Tiefe vollflächig abzutragen, daß eine gemäß der replizierten Struktur musterförmig strukturierte elektrische Funktionsschicht 50 verbleibt. Die Abtragung der Funktionsschicht 50 kann hier beispielsweise durch Ätzen oder ein sonstiges Ablationsverfahren, beispielsweise durch Laserablation, erfolgen.

Bei den Schichten 49 und 50 kann es sich jeweils um eine organische Isolationsschicht, eine Schicht aus einem organisch leitfähigen Material oder eine Schicht aus einem organischen Halbleitermaterial handeln, die als Funktionsschicht eines Bauelements in organischer Halbleitertechnologie verwendet wird. Bei der Schicht 48 kann es sich ebenfalls um eine derartige Funktionsschicht oder um eine Hilfsschicht handeln, die lediglich die Strukturierung einer elektrischen Funktionsschicht unterstützt.

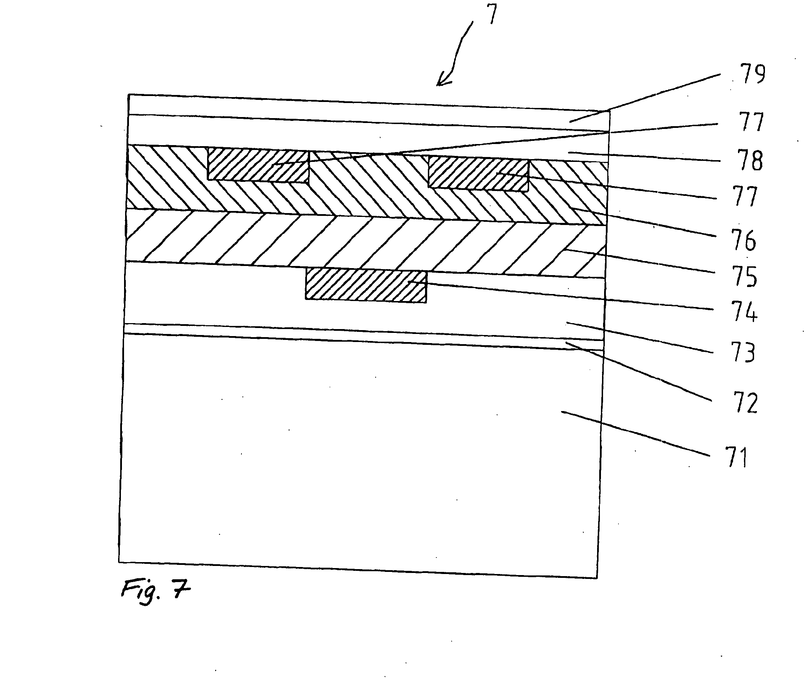

Fig. 7 zeigt nun ein Ausführungsbeispiel einer erfindungsgemäßen Folie, die über elektrische Funktionsschichten verfügt, die gemäß des anhand von Fig. 6a bis Fig. 6e erläuterten Verfahrens musterförmig strukturiert worden sind.

Fig. 7 zeigt eine Prägefolie 7 mit einer Trägerfolie 71, einer Ablöseschicht 72, einer Lackschicht 73, einer Isolationsschicht 75, einer Schicht 76 aus einem organischen Halbleitermaterial, zwei Elektrodenschichten 74 und 77, einer Lackschicht 78 und einer Kleberschicht 79.

Die Schicht 73 wird von einer Replizierlackschicht gebildet, die aus einem transparenten, thermoplatischen Kunststoffmaterial besteht.

Beispielsweise kann die Lackschicht 73 folgende Zusammensetzung besitzen:

| Komponente | Gewichtsteile |
|---|---|
| | |
| hochmolekulares PMMA-Harz | 2000 |
| Silikonalkyd ölfrei | 300 |
| nichtionisches Netzmittel | 50 |
| niedrigviskose Nitrocellulose | 750 |
| Methylethylketon | 1200 |
| Toluol | 2000 |
| Diacetonalkohol | 2500 |

In die Schicht 73 wird nun eine räumliche Struktur repliziert, die Schicht 74 aus einem organisch leitfähigen Material, beispielsweise Polyanilin oder Polypyrrol mittels eines Beschichtungsverfahrens aufgebracht und sodann ausgehärtet, so daß sich der anhand von Fig. 6b und Fig. 6c erläuterte Effekt ergibt. Anschließend wird die Isolationsschicht 75 vollflächig, beispielsweise mittels eines Druckverfahrens, aufgebracht. Die Isolationsschicht 75 kann hierbei aus dem selben Material wie die Lackschicht 73 bestehen. Anschließend erfolgt der vollflächige Aufdruck der Schicht 76 aus einem organischen Halbleitermaterial, beispielsweise Polythiophen. In die Schicht 76 wird nun eine Struktur repliziert, die Schicht 77 aus einem elektrisch leitfähigen Material aufgebracht und ausgehärtet, wobei sich der anhand der Fig. 6b und Fig. 6c erläuterte Effekt ergibt.
Anschließend werden die Lackschichten 78 und die Kleberschicht 79 vollflächig, beispielsweise mittels einer Tiefdruckwalze, aufgedruckt.

Natürlich ist es auch denkbar, die im Stand der Technik beschriebene Formschicht durch Replizierverfahren herzustellen und anschließend mit dem Rakelverfahren die Strukturierung der OFET-Schichten vorzunehmen. Bezüglich dieses Standes der Technik wird auf den in der Beschreibungseinleitung angeführten Stand der Technik verwiesen.

Weiter sind natürlich zusätzliche, in den Figuren 1 und 2 nicht dargestellte Schichten, insbesondere holographisch-optische Schichten, optisch wirkende Dünnfilmschichten, Schutzschichten usw., vorstellbar.

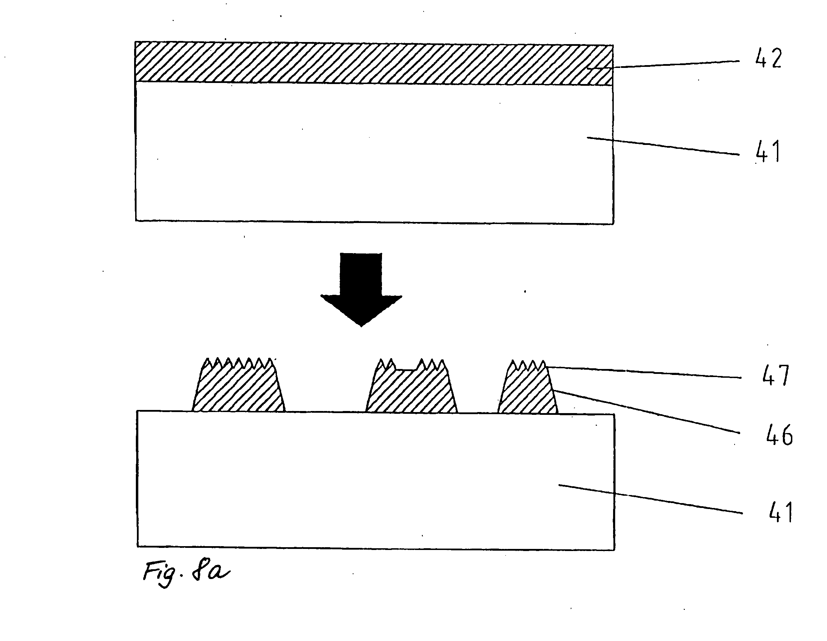

Hierbei ist es vorteilhaft, die elektrische Funktionalität (der organischen Halbleiterschaltung) mit optischen Merkmalen zu kombinieren. Beides wird in einem Schritt während des Repliziervorganges erzeugt, wie dies in Fig. 8a dargestellt ist. Es ist insbesondere denkbar, die mit den diffraktiv-optischen Strukturen versehenen Bauelementstrukturen so anzuordnen, daß ein besonderer optischer Eindruck, zum Beispiel ein Fimenlogo, entsteht. Eine besondere Fälschungssicherheit ergibt sich dadurch, daß die diffraktiven Strukturen in verschiedenen Höhenlagen des Schichtsystems, insbesondere auch übereinander, angeordnet sein können. Das sich so ergebende optisch-elektrische Element eignet sich demnach hervorragend als Sicherheitselement für Banknoten, Dokumente und zur Sicherung von Waren und Datenträgern gegenüber Fälschungen.

Fig. 8a zeigt nun die funktionelle Darstellung eines Repliziervorganges, bei dem gleichzeitig eine diffraktive, optische Struktur für ein optisches Sicherheitsmerkmal eingebracht wird und eine Strukturierung einer elektrischen Funktionsschicht erfolgt. Fig. 8a zeigt so die Trägerfolie 41 und die Schicht 42 nach Fig. 4a, Fig. 4b, Fig. 4c oder Fig. 6a. Wie in Fig. 8a gezeigt, wird in die Schicht 42 eine Struktur 47 repliziert, die sich aus der Überlagerung einer Makrostruktur und einer Mikrostruktur zusammensetzt. Die Makrostruktur führt zu einer musterförmigen Strukturierung der Schicht 42, so daß sich die musterförmig strukturierte, elektrische Funktionsschicht ergibt. Die Mikrostruktur beschreibt eine Feinstrukturierung der Oberfläche der replizierten Schicht 46. Die Mikrostruktur wird vorzugsweise von einer diffraktiv-optischen Struktur gebildet, die beispielsweise ein Hologramm oder beugungsoptische Effekte, wie Kinegram, Kineform und ähnliches, generiert. Bei der Mikrostruktur kann es sich natürlich auch um eine Beugungsstruktur nullter Ordnung handeln, die spezielle Farb- und Farbkippeffekte erzeugt. Weiter ist es auch möglich, daß die Mikrostruktur von einer isotropen oder anisotropen Mattstruktur gebildet wird.

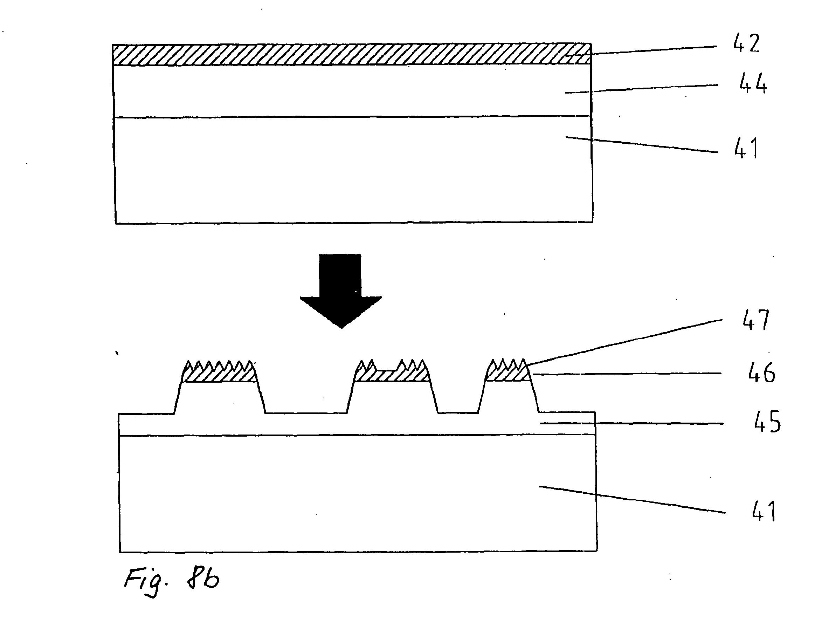

Dabei ist es besonders bevorzugt, daß bei thermischer Replikation die Strukturtiefe größer als die Schichtdicke der Schicht 42 gewählt wird. Hierbei ist es vorteilhaft, wie in Fig. 8b gezeigt, unterhalb der Schicht 42 eine weitere Lackschicht 44, vorzugsweise aus einem Replizierlack vorzusehen. Die Prägematrize der Replizierwalze kann so die Schicht 42 durchprägen, ohne daß eine Schädigung der unterhalb der Lackschichten 44 liegenden Trägerfolie bzw. weiterer Schichten zu beobachten ist.

Auf die Schicht 46 wird anschließend eine (Lack)-Schicht aus einem Material aufgebracht, dessen Brechungsindex sich von dem Brechungsindex des für die Schicht 46 verwendeten Materials deutlich unterscheidet, so daß die von der Mikrostruktur generierten optischen Effekte für einen Betrachter sichtbar werden. Alternativ kann zusätzlich eine Reflexionsschicht als vollständig oder partiell aufgebrachte Metallschicht oder HRI-Schicht auf die Schicht 46 aufgebracht werden (HRI = High Refraction Index). Als Materialien für die Reflexionsschicht kommen im wesentlichen Chrom, Aluminium, Kupfer, Eisen, Nickel, Silber, Gold oder eine Legierung mit diesen Materialien in Frage.

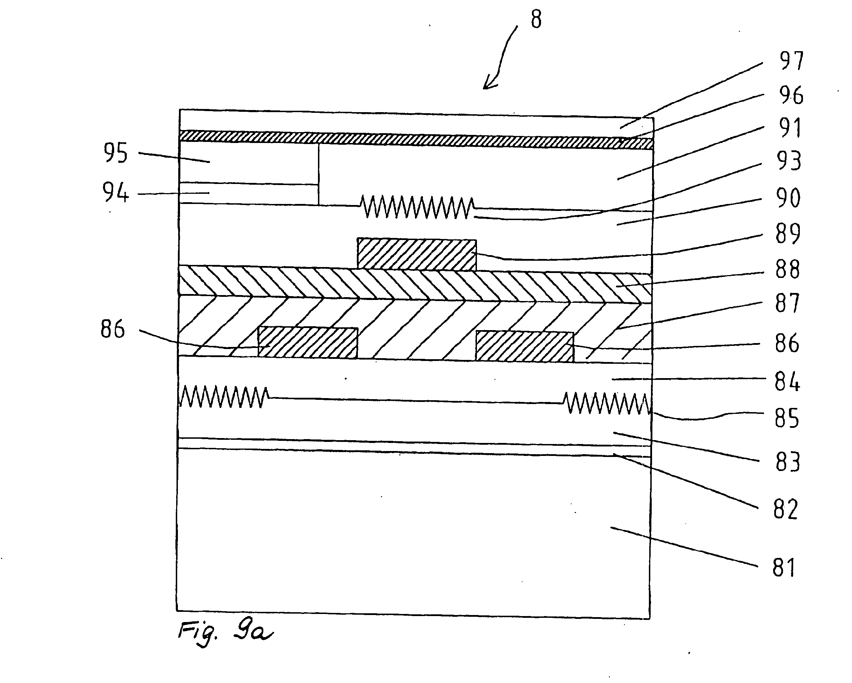

Fig. 9a zeigt nun eine weitere Möglichkeit, innerhalb einer Folie Funktionen eines elektronischen Bauelements in elektronischer Halbleitertechnologie mit optischen Sicherheitsmerkmalen zu kombinieren.

Fig. 9a zeigt eine Prägefolie 8 mit einer Trägerfolie 81, einer Ablöseschicht 82, zwei Lackschichten 83 und 84, einer ersten Elektrodenschicht 86, einer Isolationsschicht 87, einer Schicht 88, bestehend aus einem organischen Halbleitermaterial, einer zweiten Elektrodenschicht 89, einer Lackschicht 90, einer Lackschicht 91, einem Dünnfilmschichtsystem, bestehend aus einer Absorptionsschicht 94 und einer Distanzschicht 95, einer Reflexionsschicht 96 und einer Kleberschicht 97.

Die erste und zweite Elektrodenschicht 86 und 89, die Isolationsschicht 87 und die Schicht 88 aus einem organischen Halbleitermaterial sind wie die entsprechenden Schichten nach Fig. 1 und Fig. 2 ausgestaltet. Eine Strukturierung der Elektrodenschichten 86 und 89 kann beispielsweise mittels der anhand der Figuren Fig. 3 bis Fig. 4c beschriebenen Replizierverfahren erfolgen.

Bei der Schicht 83 handelt es sich um eine Replizierlackschicht, in die eine beugungsoptische Struktur 85 eingeprägt ist. Anschließend wird die Lackschicht 84 aufgebracht, die aus einem Material besteht, dessen Brechungsindex sich deutlich von dem Brechungsindex der Lackschicht 83 unterscheidet. Wie in Fig. 9a gezeigt, ist die Beugungsstruktur 85 nicht vollflächig, sondern partiell ausgeführt. Bei der Schicht 90 handelt es sich ebenfalls um eine Replizierschicht, in die eine beugungsoptische Struktur 93 eingeprägt ist. Auf die Schicht 90 wird partiell und musterförmig die Lackschicht 91 aufgebracht, deren Brechungsindex sich deutlich von dem Brechungsindex der Schicht 90 unterscheidet. Auch die beugungsoptische Struktur 93 ist lediglich partiell vorgesehen, so daß sich das von der beugungsoptischen Struktur 93 erzeugte optische Merkmal mit dem von der Struktur 85 erzeugten optischen Merkmal überlagert und ergänzt.

Das Dünnfilmschichtsystem besteht aus der Absorptionsschicht 94 (vorzugsweise mit 30 % bis 65 % Transmission), der transparenten Distanzschicht 85 als farbwechselerzeugende Schicht (z.B. λ-viertel oder λ-halbe Schicht) und der Reflexionsschicht 96 oder einer optischen Trennschicht, falls das Dünnfilmschichtsystem als transmittierendes Element wirken soll.

Die Schichten 94, 95 und 96 erzeugen eine blickwinkelabhängige Farbverschiebung mittels Interferenz. Die von dem Dünnfilmschichtsystem erzeugten Farbverschiebungen liegen hierbei vorzugsweise im Bereich des für einen menschlichen Betrachter sichtbaren Lichtes.

Weiter ist es möglich, ein Dünnfilmelement aus einer Abfolge von hoch- und niedrigbrechenden Schichten aufzubauen. Beispielsweise kann ein solches Dünnfilmelement aus drei bis neun solcher Schichten oder aus zwei bis zehn solcher Schichten aufgebaut sein. Je höher die Anzahl der Schichten ist, um so schärfer lassen sich die Wellenlängen für den Farbwechseleffekt einstellen.

Die Reflexionsschicht 96 kann als vollflächige oder partielle Metallschicht oder HRI-Schicht ausgebildet sein (HRI = High Refraction Index). Als Materialien für die Reflexionsschicht kommen so im wesentlichen Chrom, Aluminium, Kupfer, Eisen, Nickel, Silber, Gold oder eine Legierung mit diesen Materialien in Frage.

Weiter ist es auch möglich, daß die Lackschichten 83, 84, 90 und 91 eingefärbt sind. Die Schichten 86, 87, 88 und 89 sind vorzugsweise transparent oder vollflächig eingefärbt ausgeführt, so daß diese elektrischen Funktionsschichten den optischen Eindruck des Folienelements nicht beeinflussen. Weiter ist es natürlich auch möglich, daß bei der Replikation der Elektrodenschichten 86 und 87 ein Replikationsverfahren nach Fig. 8a oder Fig. 8b gewählt ist, so daß die bisher in Fig. 9a verdeutlichten optischen Effekte noch von zusätzlichen optischen Effekten überlagert werden. Auch hier ist es vorteilhaft, daß die so erzeugten optischen Effekte sich beispielsweise mit den von den diffraktiven Strukturen 85 und 93 erzeugten optischen Effekten ergänzen und dadurch eine Manipulation oder Änderung einer dieser Effekte für den Betrachter unmittelbar erkennbar wird.

Es ist natürlich auch möglich, daß in einer erfindungsgemäßen Folie nicht alle der anhand von Fig. 9a verdeutlichten optischen Effekte verwirklicht werden, sondern daß in einer solchen Folie nur eine Auswahl dieser Effekte implementiert wird.

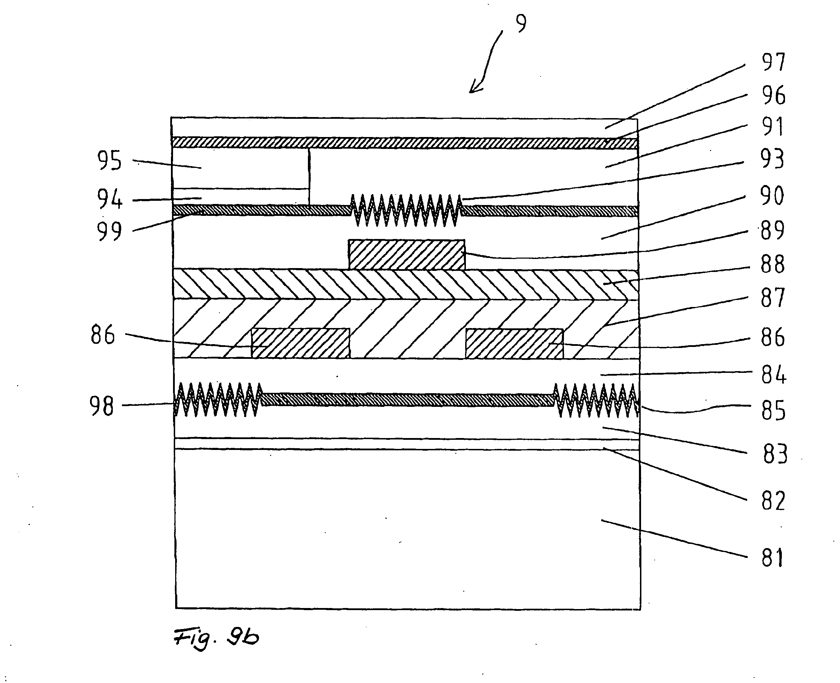

Fig. 9b zeigt eine Variante des Folienaufbaus, bei dem zusätzliche Reflexionsschichten 98 und 99 als Metallschichten oder HRI-Schichten vollflächig oder partiell auf die Schicht 83 bzw. die Schicht 90 aufgebracht sind. Hierbei ist es nicht erforderlich, daß sich die Brechungsindices der für die Schichten 84 bzw. 83 verwendeten Materialien unterscheiden. Ebenso ist es nicht erforderlich, daß sich die Brechungsindices der für die Schicht 90 bzw. die Schicht 91 verwendeten Materialien unterscheiden.

## Patentansprüche

1. Folie (1, 3, 6, 7, 8, 9), wobei die Folie (1, 3, 6, 7, 8, 9) mindestens ein Bauelement in organischer Halbleitertechnologie, insbesondere einen oder mehrere organische Feldeffekttransistoren, beinhaltet
**dadurch gekennzeichnet,**
**dass** eine elektrische Funktionalität, insbesondere die mindestens eines elektronischen Bauelementes in organischer Halbleitertechnologie, mit optischen Merkmalen kombiniert ist, wobei
a) die Folie eine zwischen Schichten der Folie abgeformte räumliche Struktur (47) aufweist, die zum einen eine Schicht (46) des elektronischen Bauelements in organischer Halbleitertechnologie musterförmig strukturiert und zum anderen einen beugungsoptischen Effekt als optisches Merkmal generiert, oder
b) die Folie eine Präge- oder Laminierfoüe ist, welche eine oder mehrere an Funktionspolymerschichten-angrenzende Lackschichten (13, 18, 63, 68, 73, 78, 84, 90) aufweist, wobei die Folie eine holoqraphisch optische oder diffraktive Schicht aufweist.

2. Folie nach Anspruch 1,
**dadurch gekennzeichnet,**
**daß** im Fall a) die räumliche Struktur (47) von einer Überlagerung einer Mikro- und einer Makrostruktur gebildet ist, wobei die Makrostruktur der musterförmigen Strukturierung einer Schicht (46) des elektronischen Bauelementes in organischer Halbleitertechnologie dient und die Mikrostruktur der Generierung des optischen Merkmals dient.

3. Folie (1, 3, 6, 7, 8, 9) nach Anspruch 1,
**dadurch gekennzeichnet,**
**daß** im Fall b) die Präge- oder Laminierfolie eine Trägerfolie (11, 61, 71, 81), zumindest eine Schicht (16, 67, 76, 88) aus einem organischen Halbleitermaterial, insbesondere Polythiophen, zumindest eine Schicht (15, 65, 75, 87) aus einem elektrisch isolierenden Material und zwei oder mehr bereichsweise musterförmig ausgeformte Schichten (14, 17, 19, 64, 66, 74, 77, 86, 89) aus einem elektrisch leitfähigen Material aufweist.

4. Folie (1, 3, 6, 7, 8, 9) nach Anspruch 3,
**dadurch gekennzeichnet,**
**daß** die Folie eine Prägefolie ist, die eine Ablöseschicht (12, 62, 72, 82) und eine Kleberschicht (20, 69, 79, 97) aufweist.

5. Folie (8) nach einem der vorhergehenden Ansprüche,
**dadurch gekennzeichnet,**
**daß** die Folie eine Dünnfilmschichtfolge (94, 95) aufweist.

6. Folie nach einem der vorhergehenden Ansprüche,
**dadurch gekennzeichnet,**
**daß** die Folie eine Dekorschicht aufweist.

7. Folie (8) nach einem der vorhergehenden Ansprüche,
**dadurch gekennzeichnet,**
**daß** die Folie (8) zwei oder mehr übereinander angeordnete Schichten (83, 84, 90, 91, 94, 95) aufweist, die ein optisches Sicherheitsmerkmal generieren, wobei eine oder mehrere Funktionsschichten (86, 87, 88, 89) des elektronische Bauelements in organischer Halbleitertechnologie zwischen solchen optisch aktiven Schichten angeordnet sind.

8. Folie (1, 3, 6, 7, 8, 9) nach Anspruch 3,
**dadurch gekennzeichnet,**
**daß** die elektrisch leitfähigen Schichten, die Schicht aus einem Halbleitermaterial und die Schicht aus einem elektrisch isolierenden Material transparent sind.

9. Folie nach einem der vorhergehenden Ansprüche,
**dadurch gekennzeichnet,**
**daß** bei der Folie durch thermisches Replizieren oder UV-Replizieren von einer oder mehreren Schichten eine Strukturierung von Funktionsschichten des Bauelements in organischer Halbleitertechnologie vorgenommen ist.

10. Folie nach einem der vorhergehenden Ansprüche,
**dadurch gekennzeichnet,**
**daß** die Folie als Sicherheitselement verwendet wird.

11. Verfahren zur Herstellung einer Folie (1, 3, 6, 7, 8, 9) nach Anspruch 1,
**dadurch gekennzeichnet,**
**daß** die Strukturierung von einer oder mehreren Schichten (43, 49, 50) des mindestens einen Bauelements in organischer Halbleitertechnologie durch thermisches Replizieren oder UV-Replizieren erfolgt, wobei durch einen Repliziervorgang eine elektrische Funktionalität, insbesondere ein oder mehrerer Bauelemente in organischer Halbleitertechnologie, und eine optische Funktionalität, insbesondere diffraktiv-optische Strukturen erzeugt werden.

## Claims

1. Film (1, 3, 6, 7, 8, 9), wherein the film (1, 3, 6, 7, 8, 9) contains at least one component in organic semi-conductor technology, in particular one or more field effect transistors,
**characterised in that**,
an electrical functionality, in particular the at least one electronic component in organic semi-conductor technology, is combined with optical features, wherein
a) the film has a spatial structure (47) formed between layers of the film, which on the one hand structures a layer (46) of the electronic component in organic semi-conductor technology in a pattern, and on the other hand generates an optically diffractive effect as an optical feature, or
b) the film is an embossed or laminated film, which has one or more lacquer layers (13, 18, 63, 68, 73, 78, 84, 90) adjoining functional polymer layers, wherein the film has a holographically optical or diffractive layer.

2. Film according to claim 1,
**characterised in that**,
in case a), the spatial structure (47) is formed from an overlapping of a micro and a macro structure, wherein the macro structure serves for the patterned structuring of a layer (46) of the electronic component in organic semi-conductor technology and the micro structure serves for the generation of the optical feature.

3. Film (1, 3, 6, 7, 8, 9) according to claim 1,
**characterised in that**,
in case b), the embossed or laminated film has a carrier film (11, 61, 71, 81), at least one layer (16, 67, 76, 88) made from an organic semi-conductor material, in particular polythiophene, at least one layer (15, 65, 75, 87) made from an electrically insulating material and two or more layers (14, 17, 19, 64, 66, 74, 77, 86, 89) formed with patterning in certain regions, which is made from an electrically conductive material.

4. Film (1, 3, 6, 7, 8, 9) according to claim 3,
**characterised in that**,
the film is an embossed film that has a detachable layer (12, 62, 72, 82) and an adhesive layer (20, 69, 79, 97).

5. Film (8) according to one of the preceding claims,
**characterised in that**,
the film has a thin-film layer sequence (94, 95).

6. Film according to one of the preceding claims,
**characterised in that**,
the film has a decorative layer.

7. Film (8) according to one of the preceding claims,
**characterised in that**,
the film (8) has two or more layers (83, 84, 90, 91, 94, 95) arranged above one another, which generate an optical security feature, wherein one or more functional layers (86, 87, 88, 89) of the electronic component in organic semi-conductor technology are arranged between such optically active layers.

8. Film (1, 3, 6, 7, 8, 9) according to claim 3,
**characterised in that**,
the electrically conductive layers, the layer made from a semi-conductor material and the layer made from an electrically insulating material are transparent.

9. Film according to one of the preceding claims,
**characterised in that**,
a structuring of functional layers of the component in organic semi-conductor technology is carried out for the film by thermal replication or UV replication of one or more layers.

10. Film according to one of the preceding claims,
**characterised in that**,
the film is used as a security element.

11. Method for the production of a film (1, 3, 6, 7, 8, 9) according to claim 1,
**characterised in that**,
the structuring of one or more layers (43, 49, 50) of the at least one component in organic semi-conductor technology takes place by thermal replication or UV replication, wherein an electrical functionality, in particular one or more components in organic semi-conductor technology, and an optical functionality, in particularly diffractively optical structures, are generated by a replication process.

## Revendications

1. Film (1, 3, 6, 7, 8, 9), sachant que le film (1, 3, 6, 7, 8, 9) comporte au moins un composant relevant de la technologie des semi-conducteurs organiques, en particulier un ou plusieurs transistors organiques à effet de champ,
**caractérisé en ce que**
une fonctionnalité électrique, en particulier la fonctionnalité d'au moins un composant électronique relevant de la technologie des semi-conducteurs organiques, est combinée à des caractéristiques optiques, sachant que
a) le film présente une structure tridimensionnelle (47) formée entre des couches du film, laquelle structure d'une part, sous la forme d'un motif, une couche (46) du composant électronique relevant de la technologie des semi-conducteurs organiques et génère d'autre part un effet optique de diffraction en tant que caractéristique optique, ou
b) le film est un film d'estampage ou un film de laminage, lequel présente une ou plusieurs couches de vernis (13, 18, 63, 68, 73, 78, 84, 90) adjacentes aux couches polymères fonctionnelles, sachant que le film présente une couche holographique ou diffractive.

2. Film selon la revendication 1,
**caractérisé en ce**
**que** dans le cas a), la structure tridimensionnelle (47) est formée par une superposition d'une microstructure et d'une macrostructure, sachant que la macrostructure sert à la structuration, sous la forme d'un motif, d'une couche (46) du composant électronique relevant de la technologie des semi-conducteurs organiques et que la microstructure sert à la génération de la caractéristique optique.

3. Film (1, 3, 6, 7, 8, 9) selon la revendication 1,
**caractérisé en ce que**
dans le cas b) le film d'estampage ou le film de laminage présente un film de support (11, 61, 71, 81), au moins une couche (16, 67, 76, 88) constituée d'un matériau semi-conducteur organique, en particulier de polythiophène, au moins une couche (15, 65, 75, 87) constituée d'un matériau isolant électriquement et deux couches (14, 17, 19, 64, 66, 74, 77, 86, 89) ou plus formées sous la forme d'un motif par endroits et constituées d'un matériau électroconducteur.

4. Film (1, 3, 6, 7, 8, 9) selon la revendication 3,
**caractérisé en ce que**
le film est un film d'estampage, qui présente une couche de séparation (12, 62, 72, 82) et une couche de colle (20, 69, 79, 97).

5. Film (8) selon l'une quelconque des revendications précédentes,
**caractérisé en ce que**
le film présente une série de couches constituées d'un film mince (94, 95).

6. Film selon l'une quelconque des revendications précédentes,
**caractérisé en ce que**
le film présente une couche décorative.

7. Film (8) selon l'une quelconque des revendications précédentes,
**caractérisé en ce que**
le film (8) présente deux couches (83, 84, 90, 91, 94, 95) ou plus disposées les unes sur les autres, lesquelles génèrent une caractéristique de sécurité optique, sachant qu'une ou plusieurs couches fonctionnelles (86, 87, 88, 89) du composant électronique relevant de la technologie des semi-conducteurs organiques sont disposées entre des couches optiquement actives de ce type.

8. Film (1, 3, 6, 7, 8, 9) selon la revendication 3,
**caractérisé en ce que**
les couches électroconductrices, la couche constituée d'un matériau semi-conducteur et la couche constituée d'un matériau isolant électriquement sont transparentes.

9. Film selon l'une quelconque des revendications précédentes,
**caractérisé en ce que**
une structuration de couches fonctionnelles du composant relevant de la technologie des semi-conducteurs organiques est effectuée dans le cas du film par réplication thermique ou par réplication infrarouge.

10. Film selon l'une quelconque des revendications précédentes,
**caractérisé en ce que**
le film est utilisé en tant qu'élément de sécurité.

11. Procédé servant à fabriquer un film (1, 3, 6, 7, 8, 9) selon la revendication 1,
**caractérisé en ce que**
la structuration d'une ou de plusieurs couches (43, 49, 50) du composant au moins au nombre de un relevant de la technologie des semi-conducteurs organiques est effectuée par réplication thermique ou par réplication infrarouge, sachant que sont générés par une opération de réplication, une fonctionnalité électrique, en particulier un ou plusieurs composants relevant de la technologie des semi-conducteurs organiques, et une fonctionnalité optique, en particulier des structures de diffraction optique.
